(19) Europäisches Patentamt
European Patent Office
Office européen des brevets

(11) **EP 4 730 214 A1**

(12) **EUROPEAN PATENT APPLICATION**

(43) Date of publication:
**22.04.2026 Bulletin 2026/17**

(21) Application number: **24206694.2**

(22) Date of filing: **15.10.2024**

(51) International Patent Classification (IPC):
*G06N 10/40* (2022.01)     *H10N 60/01* (2023.01)
*H10N 60/80* (2023.01)     *H10N 69/00* (2026.01)

(52) Cooperative Patent Classification (CPC):
**G06N 10/40; H10N 60/0912; H10N 60/805;
H10N 69/00**

(84) Designated Contracting States:
**AL AT BE BG CH CY CZ DE DK EE ES FI FR GB
GR HR HU IE IS IT LI LT LU LV MC ME MK MT NL
NO PL PT RO RS SE SI SK SM TR**
Designated Extension States:
**BA**
Designated Validation States:
**GE KH MA MD TN**

(71) Applicants:
• **Imec VZW
3001 Leuven (BE)**
• **Katholieke Universiteit Leuven
KU Leuven Research & Development
3000 Leuven (BE)**

(72) Inventors:
• **VAN DAMME, Jacques
3000 Leuven (BE)**
• **PEREZ LOZANO, Daniel
1030 Schaerbeek (BE)**
• **IVANOV, Tsvetan
3001 Heverlee (BE)**

(74) Representative: **Winger
Mouterij 16 bus 101
3190 Boortmeerbeek (BE)**

(54) **TRI-LAYER MERGED-ELEMENT TRANSMON QUBIT**

(57)     A quantum circuit and related manufacturing method are disclosed. The quantum circuit comprises a vertical Josephson junction (1001) formed by a bottom electrode (810) in a first superconducting material layer, a tunnel barrier (830), and a top electrode (820) in a second superconducting material layer. A contact portion (811) and a coupling portion (812) of the bottom electrode are located inside and outside the Josephson junction, respectively. A transmon qubit of the quantum circuit comprises the Josephson junction and a shunt capacitor formed by the top electrode and the contact portion of the bottom electrode as capacitor plates. A readout circuit is capacitively coupled to the bottom electrode through the coupling portion and includes a coupling head (861). The coupling portion is fitted into a recessed portion of the coupling head. The top electrode is configured as a floating electrode, not resistively coupled to the first superconducting material layer.

FIG. 10

# Description

## Field of the invention

The present invention relates to the field of superconducting quantum circuits, and more specifically to a tri-layer merged-element transmon qubit device.

## Background of the invention

Ingeniously exploiting the phenomena of quantum superimposition, interference and entanglement, quantum computers promise to solve complex computational problems far more efficiently than today's most powerful classical computers. Various scalable qubit implementations for accurate quantum computing are currently being explored but demand great efforts and are technologically challenging. A widely pursued and promising approach to qubit implementations for quantum computing applications uses superconducting circuits that include a Josephson junction.

A transmon is a superconducting qubit in which the Josephson junction is electrically connected in parallel with a shunt capacitor that has a large capacitance compared to the stray capacitance of the Josephson junction. This results in superconducting qubits that are significantly less sensitive to charge noise but preserve a sufficient degree of anharmonicity in the quantum states. Mostly present on surfaces and interfaces, material defects and imperfections have a large adverse effect on the quantum coherence properties of transmon qubits, which are yet so essential to high-fidelity quantum computing applications. To minimize their impact, the shunt capacitors of transmons are commonly realized as large coplanar devices. Unfortunately, this approach leads to transmons qubits with large device footprints near to square millimeters, which lack the required compactness for scaling to high areal density qubit processors.

A merged-element transmon qubit with reduced device dimensions has been described in Zhao, Ruichen, et al. "Merged-element transmon", Physical Review Applied, vol. 14, issue 6, 2020. Therein, the large external shunt capacitor has been replaced by the self-capacitance of the Josephson junction. The merged-element transmon qubit structure has been etched into a sputtered Nb/a-Si/Nb tri-layer and an Nb air bridge is formed over the qubit device to electrically connect the qubit top electrode to ground. However, a protective amorphous dielectric filler material needs to be applied to the transmon qubit while forming the Nb air bridge and is removed thereafter. This process creates new material defects and imperfections in and around the Josephson junction region, causing the qubit device to perform poorly in terms of the achievable coherence times.

There is a need for compact transmon qubit circuitry with improved coherence properties.

## Summary of the invention

It is an object of embodiments of the present invention to provide a transmon qubit with improved coherence properties. This objective is accomplished by a quantum circuit comprising a vertical junction merged-element transmon qubit and a related manufacturing method in accordance with the claims.

In one aspect, the present invention relates to a quantum circuit comprising a vertical Josephson junction and a transmon qubit. The vertical Josephson junction is formed over a substrate and comprises a bottom electrode, a tunnel barrier and a top electrode. A contact portion of the bottom electrode is located inside the vertical Josephson junction, whereas a coupling portion of the bottom electrode is located outside the vertical Josephson junction. The bottom electrode is formed in a first superconducting material layer and the top electrode is formed in a second superconducting material layer. The transmon qubit comprises the vertical Josephson junction and a shunt capacitor which is formed by overlapping portions of the top electrode and the bottom electrode within the vertical Josephson junction. A readout circuit, comprising a coupling head, is capacitively coupled to the bottom electrode through the coupling portion. The coupling portion of the bottom electrode is fitted into/engages a recess of the coupling head of the readout circuit. This means that interlocking of the bottom electrode coupling portion and the readout circuit coupling head can be established in a non-contact manner, which allows capacitive coupling between the bottom electrode and the readout circuit for qubit state measurement. The top electrode of the vertical Josephson junction is configured as a floating electrode, not resistively coupled to the first superconducting material layer.

In embodiments, a vertical direction can be defined by the vertical Josephson junction, i.e. the contact portion of the bottom electrode, the tunnel barrier and the top electrode are provided in different material layers that are stacked vertically.

In embodiments, the top electrode and the contact portion of the bottom electrode act as opposite capacitor plates of the shunt capacitor of the transmon qubit. This allows the reduction or cancellation of charge noise and eliminates the need for an additional shunting capacitor, external to the Josephson junction.

In embodiments, the coupling portion of the bottom electrode acts as a coupling capacitor with respect to the coupling head portion of the readout circuit. In embodiments, the recess in the coupling head of the readout circuit may be formed as a receiving slot with respect to the coupling portion of the bottom electrode. This optimizes the capacitive coupling. Providing the bottom electrode with a dedicated coupling portion outside the Josephson junction has the advantage that the Josephson junction and the coupling to the readout circuit can be designed nearly independently, with less constraints and more design freedom. This also allows improved capacitive coupling between the bottom electrode and the readout circuit to obtain stronger readout signals and reduces parasitic capacitive coupling between the top electrode and the readout circuit.

In embodiments, the readout circuit can be configured for dispersive readout of the qubit state (e.g., configured to induce and detect a dispersive shift of the resonance frequency of a readout resonator coupled to the transmon qubit). Furthermore, the readout circuit may comprise a readout resonator. The readout resonator may be provided as a coplanar waveguide, which is simple to realize with high quality factors, exhibits low dispersion and good broadband operation, does not suffer from uncontrolled stray inductances or capacitances, and has a characteristic impedance value that can be controlled accurately. Readout resonator quality factors $Q \geq 30000$ and normalized dispersive shifts $|\chi|/\kappa > 1,0$ can be obtained ($\chi$ represents the amount of dispersive shift and $\kappa$ is the linewidth of the readout resonator). For instance, transmon qubit state-dependent readout resonator dispersive shifts of the order of 100 kHz can be achieved, which is compatible with readout resonator linewidths up to 100 kHz. The readout resonator may be formed in the first superconducting material layer. The impedance value of the readout resonator may be at least 100 Ohm. In embodiments, the readout circuit may further comprise a transmission line that is electrically (e.g. capacitively) coupled to the readout resonator. To simplify circuit fabrication, the transmission line may be formed in the first superconducting material layer too.

In embodiments, the readout circuit may be formed in the first superconducting material layer to achieve coplanar capacitive coupling with the bottom electrode via the coupling head portion of the readout circuit and the coupling portion of the bottom electrode.

In embodiments, the readout circuit may be used for driving the transmon qubit, e.g. act as a driving circuit relative to the transmon qubit. This means that transitions between quantum states of the transmon qubit and/or the preparation of the transmon qubit in a particular quantum state (which can be a quantum superimposition of ground state and first excited state) can be driven or caused by the application of respective electrical pulses or pulse sequences to the readout circuit. In alternative embodiments, a separate drive line may be provided in addition to the readout circuit. This drive line may be arranged to pass or have an end portion in close proximity to the transmon qubit. In such alternative embodiments, the bottom electrode may be configured to extend out of the Josephson junction region at more than just one location along the junction periphery, thus connecting the contact portion to the coupling portion (as before) and further to a driving portion. Similar to the coupling portion, the driving portion may include a finger-like, strip-like or multi-fingered structure to allow for strong capacitive coupling with the additional drive line. The drive line may include a complementary shaped terminal section for receiving the driving portion, e.g.

resulting in an interlocking, contact-free configuration of the drive line and the driving portion of the bottom electrode similar to the interlocking, contact-free configuration of the readout circuit coupling head and the coupling portion of the bottom electrode. Moreover, the driving portion may be connected to the contact portion of the bottom electrode via a tapered section. The driving portion and the coupling portion may be connected and extend from opposite sides of the contact portion of the bottom electrode, or may be connected and extend at an angle, e.g. at a right angle, from the contact portion of the bottom electrode.

In embodiments, the bottom electrode coupling portion and the readout circuit coupling head can have complementary interlocking profiles, wherein the interlocking is loose and non-contact but includes a space between the two interlocking parts. The bottom electrode coupling portion may comprise or be formed as a prong, finger or tongue and the readout circuit coupling head may have a recess, slot or slit for receiving the corresponding prong, finger or tongue of the bottom electrode coupling portion, e.g. as in a flat or planar version of the mortise (cut-out) and tenon (tongue) interlocking profiles.

In embodiments, the quantum circuit may further comprise a ground contact region that is arranged for capacitive coupling with the contact portion of the bottom electrode. The ground contact region may be arranged adjacent to but separately from the vertical Josephson junction.

In embodiments, the ground contact region may be formed in the first superconducting material layer. The ground contact region may be structured as a ground plane adjacent to the contact portion of the bottom electrode. In embodiments, the ground contact region (e.g. ground plane) is useful for providing shielding and a voltage reference.

In embodiments, the ground contact region and the bottom electrode may be coplanar structures of the first superconducting material.

In embodiments, the ground contact region and the bottom electrode may be distanced from each other by a gap along each transverse direction, perpendicular to the vertical direction defined by the vertical Josephson junction. The dimensions of the gap may vary along the perimeter of the bottom electrode. The dimension of the gap may be smaller along the edge of the contact portion of the bottom electrode compared to the edge of the coupling portion. The dimension of the gap may increase between the contact portion and the coupling portion of the bottom electrode. The dimension of the gap may be constant along the perimeter of the contact portion of the bottom electrode, except for the connecting end of the contact portion that joins the coupling portion of the bottom electrode. Additionally, a vertical gap may separate the ground contact region and the bottom electrode along the vertical direction if the ground contact region is provided in a different material layer than the first superconducting material layer.

In embodiments, the ground contact region is arranged distantly from the bottom electrode. This means that the ground contact region does not directly contact or abut on the contact portion of the bottom electrode. A gap may be formed in the plane of the first superconducting material layer which separates the ground contact region from the bottom electrode. In embodiments, the coupling portion of the bottom electrode is preferably arranged more distantly from the ground contact region than the contact portion of the bottom electrode. A gap in the plane of the first superconducting material layer, separating the ground contact region from the bottom electrode, may be wider along a boundary or periphery of the contact portion of the bottom electrode than along a boundary or periphery of the coupling portion of the bottom electrode.

In other embodiments, the ground contact region may be formed in a third superconducting material layer atop or above the second superconducting material layer. That is, the third superconducting material layer may be in contact with/contiguous with/interfacing the second superconducting material layer or may be separated from the second superconducting material layer by one or more intermediate layers. The second superconducting material layer may be arranged between the first and the third superconducting material layer. The ground contact region may be formed in the third superconducting material layer adjacent to the top electrode but without being contiguous with or adjoining the top electrode. The ground contact region may be separated vertically (i.e. along a vertical direction of the Josephson junction) from top electrode by a height distance between the third and the second superconducting material layer and the ground contact region may be offset along a transverse direction (i.e. direction perpendicular to the vertical direction of the Josephson junction) relative to the top electrode. The offset along each transverse direction may be sufficiently large to obtain an overlap-free ground contact region which does not overlap with the top electrode in the second superconducting material layer below the third superconducting material layer. The ground contact region may be structured as a ground plane of the third superconducting material layer.

The presence of a gap between the ground contact region and the outer circumference of the Josephson junction has the advantage that the different components of the quantum circuit (transmon, ground contact, readout/drive) can be defined by (lithographic) patterning and selective removal of material (e.g. etching) from the different material layers of a prefabricated multilayered material stack or wafer. No additional functional layers for quantum circuit operation need to be deposited or grown, which may need further processing or temperature treatment. This limits the introduction or propagation of surface defects, thereby improving the coherence properties of the quantum circuit. Moreover, the gap dimension may be optimized to obtain strong capacitive coupling between the top electrode of the Josephson junction and electrical ground, whereby the readout coupling strength is improved.

Furthermore, a gap between the ground contact region and the outer circumference of the Josephson junction may extend through the interface between the bottom electrode and the substrate and partially into the substrate. A recessed portion may be defined on the upper surface of the substrate which coincides with the gapped region throughout the whole surface of the planar quantum circuit. Partially removing substrate material across the gap region causes the bottom electrode, the coupling head and the readout resonator structure to be formed on and supported by pedestals of the substrate material. This has the benefit that a larger volume portion of the electric fringing field is present in the vacuum instead of the substrate dielectric, which may further reduce dielectric losses.

In embodiments, the contact portion of the bottom electrode may correspond to the junction-forming portion of the bottom electrode that is located inside the Josephson junction.

In embodiments, the top electrode of the Josephson junction may completely overlap with the contact portion of the bottom electrode provided below the top electrode.

In embodiments, the top electrode, the tunnel barrier and the contact portion of the bottom electrode of the vertical Josephson junction may have identical shapes or outlines.

In embodiments, the vertical projections of the individual perimeters (outer edge) of the top electrode and the tunnel barrier of the vertical Josephson junction onto a common plane preferably are aligned or coincide.

In embodiments, the vertical projections of the individual perimeters (outer edge) of the top electrode, the tunnel barrier and the contact portion of the bottom electrode of the vertical Josephson junction onto a common plane may coincide.

In embodiments, the adjacent sidewalls of the top electrode and the tunnel barrier of the vertical Josephson junction (e.g. walls whose surface normal is substantially perpendicular to the vertical direction of the Josephson junction) may be contiguous with each other.

In embodiments, the outer sidewalls of adjacent ones of the top electrode, the tunnel barrier and the contact portion of the bottom electrode of the vertical Josephson junction (e.g. walls whose surface normal is substantially perpendicular to the vertical direction of the Josephson junction) may be contiguous with each other.

In embodiments, the outer sidewalls of the top electrode, the tunnel barrier and the contact portion of the bottom electrode may be vertical sidewalls, i.e., straight sidewalls rising at ninety-degree angles relative to an upper planar surface of the underlying substrate. Nonetheless, it is possible to implement outer sidewalls of the top electrode, the tunnel barrier and the contact portion of the bottom electrode that are slightly sloped, e.g. oriented at 90° +/- 20° relative to an upper planar surface of the underlying substrate.

In embodiments, the tunnel barrier may be arranged between the contact portion of the bottom electrode and the top electrode. The top electrode may be formed atop the bottom electrode and the tunnel barrier.

In embodiments, the contact portion of the bottom electrode may be covered by the tunnel barrier.

In embodiments, the tunnel barrier may be covered by the top electrode.

In embodiments, the bottom electrode may be in direct contact with or supported by the substrate.

In embodiments, the bottom electrode may be formed as a single connected structure in which the contact portion and the coupling portion are provided at opposite ends.

In embodiments, the contact portion of the bottom electrode may be directly connected to coupling portions of the bottom electrode. In other embodiments, the contact portion of the bottom electrode and the coupling portion of the bottom electrode may be connected through an intermediate connecting portion such as a tapered connecting portion of the bottom electrode.

In embodiments, the bottom electrode may comprise an intermediate portion for connecting the contact portion of the bottom electrode to the coupling portion of the bottom electrode. The intermediate portion of the bottom electrode may be located outside the vertical Josephson junction. The intermediate portion of the bottom electrode may be tapered.

In embodiments, the coupling portion of the bottom electrode may be shaped or contoured like a finger, tongue, prong or strip in the layer of the first superconducting material.

In embodiments, the coupling portion of the bottom electrode may correspond to an elongated strip or single-fingered coupling structure of the first superconducting material. In other embodiments, the coupling portion of the bottom electrode may correspond to an interdigitated multi-fingered coupling structure of the first superconducting material.

In embodiments, the coupling portion of the bottom electrode may extend along a preferential direction within the layer of the first superconducting material, e.g., may be shaped as a long and narrow piece of first superconducting material, whereby a width of the coupling portion is smaller than a length of the coupling portion. Preferably, the width of the coupling portion is larger than a (tip) width at the tip of the contact portion that is closest to the coupling portion.

In embodiments, an inner edge of the ground contact region may - without touching or intersecting - circumscribe, encircle or surround an outer edge of the contact portion of the bottom electrode in a top view of the quantum circuit. Similarly, a vertical projection of a boundary (perimeter, edge) of the ground contact region onto the plane of the first superconducting material layer may - without touching or intersecting - circumscribe, encircle or surround a boundary (perimeter, edge) of the contact portion of the bottom electrode.

In embodiments, an inner edge of the ground contact region may - without touching or intersecting - circumscribe, encircle or surround an outer edge of the top electrode in a top view of the quantum circuit, except for an end tip of the top electrode where the contact portion of the underlying bottom electrode is transitioning towards or is abutting the coupling portion of the bottom electrode. Similarly, a vertical projection of a boundary (perimeter, edge) of the ground contact region onto the plane of the second superconducting material layer may - without touching or intersecting - circumscribe, encircle or surround a boundary (perimeter, edge) of the top electrode, except for an end tip of the top electrode where the contact portion of the underlying bottom electrode is transitioning towards or is abutting the coupling portion of the bottom electrode.

In embodiments, an inner edge of the ground contact region may - without touching or intersecting - circumscribe, encircle or surround an outer edge or sidewall of the Josephson junction in a top view of the quantum circuit, except for an end tip of the Josephson junction where the contact portion of the bottom electrode is transitioning towards or is abutting the coupling portion of the bottom electrode.

In embodiments, an inner edge of the ground contact region may - without touching or intersecting - circumscribe, encircle or surround an outer edge or sidewall of the tunnel barrier in a top view of the quantum circuit, except for an end tip of the tunnel barrier where the contact portion of the bottom electrode is transitioning towards or is abutting the coupling portion of the bottom electrode. Similarly, a vertical projection of a boundary (perimeter, edge) of the ground contact region onto the plane containing the tunnel barrier may - without touching or intersecting - circumscribe, encircle or surround a boundary (perimeter, edge) of the tunnel barrier, except for an end tip of the tunnel barrier where the contact portion of the underlying bottom electrode is transitioning towards or is abutting the coupling portion of the bottom electrode.

In embodiments, the sidewalls or outer surfaces of the tunnel barrier of the Josephson junction may be interfacing air or vacuum or an inert gas.

In embodiments, the sidewalls or outer surfaces of the contact portion of the bottom electrode may be interfacing air or vacuum or an inert gas.

In embodiments, the sidewalls or outer surfaces of the bottom electrode may be interfacing air or vacuum or an inert gas.

In embodiments, the sidewalls or outer surfaces of the top electrode may be interfacing air or vacuum or an inert gas.

In merged-element transmon qubits, the electrical field is confined to the junction region. Using air, vacuum or an inert gas as a surrounding medium that interfaces the sidewalls of the vertical Josephson junction instead of a dielectric filler or substrate material has the advantage of avoiding dielectric losses that cause a decrease in the transmon qubit coherence times.

In embodiments, the vertical Josephson junction may be a tri-layer junction.

In embodiments, the tunnel barrier may be formed in a barrier layer. The first superconducting material layer, the barrier layer and the second superconducting material layer may be patterned layers of a tri-layer material stack. A tri-layer material stack may be prefabricated under optimized growth conditions for the different material layers, yielding high-quality and flat material layers even on wafer scale.

In embodiments, the barrier layer may be provided as an insulating material layer, e.g. as a dielectric layer. The dielectric layer may be a non-amorphous dielectric layer such as a crystalline dielectric layer. Non-amorphous tunnel barriers advantageously reduce losses and improve the coherence properties of the qubit.

In embodiments, the top electrode may be free of resistive electrical contacts. The contact-free top electrode may be provided in a pristine condition. The pristine condition of the top electrode may include an outward upper surface, facing away from the tunnel barrier, which is continuous and smooth and not interrupted by outwardly projecting structures. The upper surface may be free of any deposited metallic structures. Providing top electrodes without any resistive contacts has the advantage of avoiding the introduction of material defects and imperfections during contact formation.

In embodiments, the top electrode may have a smooth and continuous upper surface, which is facing away from the tunnel barrier, and a lower surface that is facing the tunnel barrier. The upper surface of the top electrode may be a planar surface. The upper surface of the top electrode may interface with vacuum, air or a protective dielectric layer over its entire surface area.

In embodiments of the invention, the capacitance of the shunt capacitor of the transmon qubit corresponds to the self-capacitance of the vertical Josephson junction. This means that the transmon qubit is of the merged-element type. Merged-element transmon qubits are beneficial in terms of increased compactness and smaller footprint since they do not require electrical connection to large external capacitors.

In embodiments, the vertical Josephson junction may have a junction length along a first direction parallel to the substrate and a junction width along a second direction parallel to the substrate, the second direction being perpendicular to the first direction, and the ratio of junction width to junction length may be at most 0.02.

In embodiments, the vertical Josephson junction may have a junction area of size 'A' and junction perimeter of length 'P' such that $P^2 \geq 200*A$.

In embodiments, the vertical Josephson junction may have an oblong shape of width 'w' and area 'A' and the gap separating the ground contact region and the vertical Josephson junction may have a gap width 'G', such that $G*w^2/A < 1$ nm.

In embodiments, one or both of the first and second superconducting material layer may comprise aluminum.

In embodiments, the tunnel barrier may be formed in a dielectric layer, preferably comprising aluminum oxide. Aluminum is a commonly used superconductor that can be easily oxidized to form high quality tunnel barriers. High-purity aluminum can be obtained at wafer scale by well-known epitaxial growth processes.

In embodiments, vertical sidewalls of the vertical Josephson junction may be free of deposited dielectric residuals.

In another aspect, the present invention relates to a method of manufacturing a quantum circuit of the previous aspect. The method comprises the steps of:

> providing a multilayer material stack comprising a first superconducting material, a dielectric layer and second superconducting material on a substrate,
> forming a bottom electrode in the first superconducting material, which comprises a contact portion and a coupling portion,
> forming a top electrode in the second superconducting material, which is configured as a floating electrode, not resistively coupled to the first superconducting material layer,
> forming a transmon qubit comprising a vertical Josephson junction and a shunt capacitor, wherein the vertical Josephson junction comprises the contact portion of the bottom electrode, a tunnel barrier formed in the dielectric layer and the top electrode, and the shunt capacitor comprises the top electrode and the contact portion of the bottom electrode as shunt capacitor plates,
> capacitively coupling a readout circuit to the bottom electrode, including interlocking without contacting the coupling portion of the bottom electrode and a recess formed in a coupling head of the readout circuit.

In embodiments, the method may further comprise the step of forming a ground contact region in the first superconducting material layer or in a third superconducting material layer atop the second superconducting material layer. The ground contact region is formed adjacent to the vertical Josephson junction. The ground contact region may have the structure of a ground plane.

In embodiments, providing the multilayer material stack may comprise depositing the first superconducting material layer, the dielectric layer and the second superconducting material layer on the substrate. Additional material layers such as a third superconducting material layer, buffer layers or seed layers may be deposited, e.g., on the second superconducting material layer or between the substrate and the first superconducting material layer. The first superconducting material layer, second superconducting material layer, tunnel barrier layer and other optional layers may be provided as films of a multilayer stack, e.g. thin films of an epitaxial stack.

In embodiments, depositing the first superconducting material layer, second superconducting material layer and/or tunnel barrier layer may include epitaxially growing these layers, or depositing these layers by sputtering, vapor deposition or atomic layer deposition techniques. Depositing the dielectric layer for the tunnel barrier may comprise depositing and subsequently oxidizing a metal or semiconductor layer, which may correspond to a thickness portion of the first superconducting material layer.

In embodiments, forming the top electrode may comprise patterning, e.g. lithographically through a resist, and selectively removing material from the second superconducting material layer. Material from the dielectric layer may be selectively removed at the same time (e.g. same removal processing step) or immediately following the selective material removal from the second superconducting material layer. If material from the dielectric layer is selectively removed together with material from the second superconducting material layer, the same pattern definitions or patterning structures may be used. That is, a thickness portion of the dielectric layer, which may include the complete thickness of the dielectric layer, may be etched together with the second superconducting material layer, which has the advantage that structures such as the Josephson junction contour are aligned for the second superconducting material layer and the dielectric layer. This avoids an additional lithographic alignment step.

In embodiments, the method may further comprise the step of forming the tunnel barrier. This may include patterning, e.g. lithographically through a resist, and selectively removing material from the dielectric layer.

In embodiments, forming the bottom electrode may comprise patterning, e.g. lithographically through a resist, and selectively removing material from the first superconducting material layer. Material from the underlying substrate may be selectively removed at the same time (e.g. same removal processing step) or immediately following the selective material removal from the first superconducting material layer. If material from the substrate is selectively removed together with material from the first superconducting material layer, the same pattern definitions or patterning structures may be used. That is, a thickness portion of the substrate may be etched together with the first superconducting material layer.

In other embodiments, forming the bottom electrode may comprise patterning, e.g. lithographically through a resist, and selectively removing material from the second superconducting material layer. The resulting pattern for the bottom electrode in the second superconducting material layer is then transferred to the first superconducting material. This may include etching through a layer thickness associated with the second superconducting material layer and into the material layers below the second superconducting material layer, e.g. into the insulating barrier layer and further into the first superconducting material layer. The top electrode may then be formed by selectively removing the excess material in the second superconducting material layer that does not contribute or belong to the top electrode structure.

In embodiments, patterning the first superconducting material layer, the dielectric layer and/or the second material layer may include the steps of depositing a resist layer, exposing the resist layer to optical or e-beam irradiation to define regions to be etched in accordance with a lithographic pattern (e.g. mask pattern), and developing the resist to define openings in the resist corresponding to the regions to be etched.

In embodiments, the selective removal of material from the first superconducting material layer, the dielectric layer and/or the second material layer may include etching away the material of these layers, e.g. in regions not protected by a resist layer.

It is an advantage of embodiments of the present invention that a floating tri-layer merged-element transmon can be fabricated from any superconductor-insulator-superconductor tri-layer stack with only two patterning steps and no further added material, promising little introduced material defects and increased qubit coherence. The Josephson junction can be kept in a pristine condition, which improves the quality of the tunnel barrier.

It is an advantage of embodiments of the present invention that the quantum circuit can serve as a vehicle for transmon qubit testing. The increased barrier sensitivity and the area insensitivity of transmon qubits can be leveraged to identify and characterize better performing Josephson junction material combinations (e.g. tri-layer stacks) and develop ways to reduce fabrication variability.

It is another advantage of embodiments of the present invention that non-oxide insulators can be used and tested as tunnel barriers.

It is yet another advantage of embodiments of the present invention that the quantum circuits can be manufactured at large qubit densities on wafer scale and in a way that is CMOS compatible. No angled shadow evaporation of Josephson junction material is required. Moreover, no protective dielectric filler or spacer materials need to be introduced during circuit fabrication, which may introduce additional interface defects along the Josephson junction sidewalls or are difficult to remove afterwards without damaging the junction.

It is a further advantage of embodiments of the present invention that the coupling between the transmon qubits and the readout circuit can be obtained by compact coupling structures, avoiding the use of extended and narrow antenna-like coupling structures.

Particular and preferred aspects of the invention are set out in the accompanying independent and dependent claims. Features from the dependent claims may be combined with features of the independent claims and with features of other dependent claims as appropriate and not merely as explicitly set out in the claims.

For purposes of summarizing the invention and the advantages achieved over the prior art, certain objects and advantages of the invention have been described herein above. Of course, it is to be understood that not necessarily all such objects or advantages may be achieved in accordance with any particular embodiment of the invention. Thus, for example, those skilled in the art will recognize that the invention may be embodied or carried out in a manner that achieves or optimizes one advantage or group of advantages as taught herein without necessarily achieving other objects or advantages as may be taught or suggested herein.

The above and other aspects of the invention will be apparent from and elucidated with reference to the embodiment(s) described hereinafter.

**Brief description of the drawings**

The invention will now be described further, by way of example, with reference to the accompanying drawings, in which:

FIG. 1 is a top view illustrating a portion of a quantum circuit in accordance with a first embodiment of the invention.
FIG. 2 is enlarged perspective view of the quantum circuit in FIG. 1.
FIG. 3 is a cross-sectional view of the Josephson junction in the quantum circuit of FIG. 1.
FIG. 4 shows the equivalent electrical circuit diagram for the quantum circuit according to the first embodiment.
FIG. 5 illustrates the frequency - junction barrier thickness relationship for a merged-element transmon qubit in accordance with embodiments of the invention.
FIG. 6 illustrates the combined impact of the circumferential gap width and the Josephson junction area aspect ratio on the coupling capacitance between the junction top electrode and the ground contact region in accordance with embodiments of the invention.
FIG. 7 illustrates the combined impact of the circumferential gap width and the Josephson junction areal aspect ratio on the readout contrast in accordance with embodiments of the invention.
FIG. 8 is a top view illustrating a portion of a quantum circuit in accordance with a second embodiment of the invention.
FIG. 9 is a magnified view of the transmon qubit in the quantum circuit of FIG. 8.
FIG. 10 is a cross-sectional view of a portion of the quantum circuit as shown in FIG. 8.

FIG. 11 illustrates steps of a method for manufacturing a quantum circuit according to embodiments of the invention.

The drawings are only schematic and are non-limiting. Any reference signs in the claims shall not be construed as limiting the scope. In the different drawings, the same reference signs refer to the same or analogous elements.

**Detailed description of illustrative embodiments**

The present invention will be described with respect to particular embodiments and with reference to certain drawings but is only limited by the claims.

It is to be noticed that the term "comprising", used in the claims, should not be interpreted as being restricted to the means listed thereafter; it does not exclude other elements or steps. It is thus to be interpreted as specifying the presence of the stated features, integers, steps or components as referred to but does not preclude the presence or addition of one or more other features, integers, steps or components, or groups thereof. Thus, the scope of the expression "a device comprising means A and B" should not be limited to devices consisting only of components A and B. It means that with respect to the present invention, the only relevant components of the device are A and B.

Reference throughout this specification to "one embodiment" or "an embodiment" means that a particular feature, structure or characteristic described in connection with the embodiment is included in at least one embodiment of the present invention. Thus, appearances of the phrases "in one embodiment" or "in an embodiment" in various places throughout this specification are not necessarily all referring to the same embodiment. Furthermore, the particular features, structures or characteristics may be combined in any suitable manner, as would be apparent to one of ordinary skill in the art from this disclosure, in one or more embodiments.

Similarly, it should be appreciated that in the description of exemplary embodiments of the invention, various features of the invention are sometimes grouped together in a single embodiment, figure, or description thereof for the purpose of streamlining the disclosure and aiding in the understanding of one or more of the various inventive aspects. This method of disclosure, however, is not to be interpreted as reflecting an intention that the claimed invention requires more features than are expressly recited in each claim. Rather, as the following claims reflect, inventive aspects lie in less than all features of a single foregoing disclosed embodiment. Thus, the claims following the detailed description are hereby expressly incorporated into this detailed description, with each claim standing on its own as a separate embodiment of this invention.

In the description provided herein, numerous specific details are set forth. However, it is understood that embodiments of the invention may be practiced without these specific details. In other instances, well-known methods, structures and techniques have not been shown in detail in order not to obscure an understanding of this description.

Hereinunder, a "tri-layer" transmon qubit, as commonly understood in the field, designates transmon qubits whose Josephson junction is etched into a prefabricated tri-layer material stack. This means that the tri-layer stack is deposited first and then etched into shape. Tri-layer transmon qubits are distinct from transmon qubits that have an overlap-type of Josephson junction, in which the bottom electrode is patterned first, the barrier layer and the top electrode layer are then deposited, followed by the etching of the top electrode structure. Moreover, tri-layertransmon qubits are also distinct from transmon qubits that have a "shadow evaporated" Josephson junction according to which the bottom electrode is first deposited under one angle, using a resist shadow mask, then partially oxidized to form the barrier layer, and finally covered by the top electrode structure that is deposited under another angle (all in-situ using the same resist pattern).

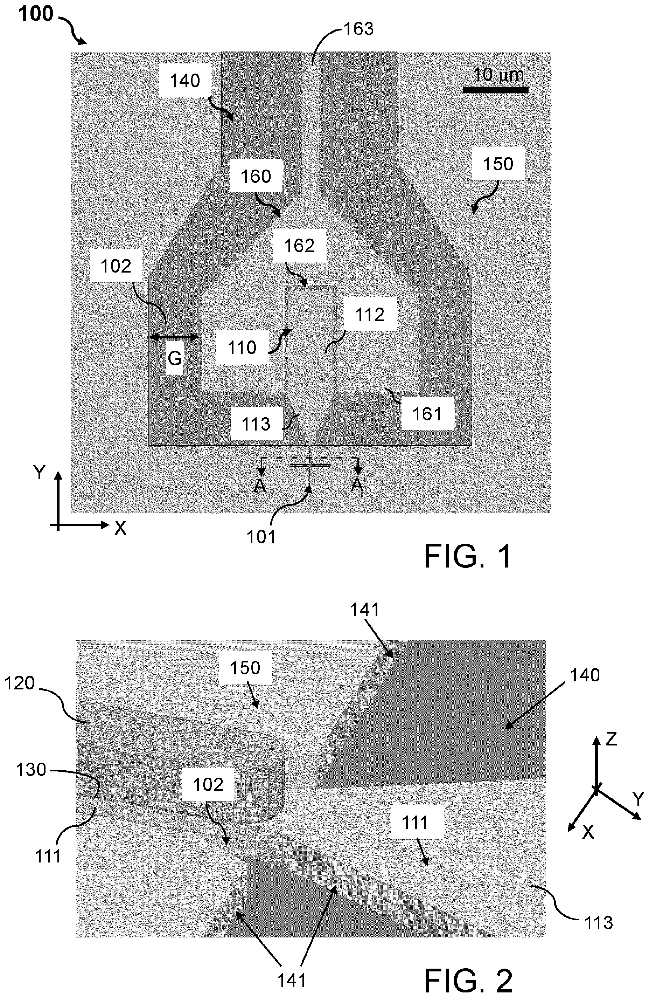

FIG. 1 is a top view illustrating a portion of a quantum circuit in accordance with a first embodiment of the invention. The quantum circuit 100 comprises a transmon qubit structure with a cross-shaped, vertically oriented Josephson junction 101. Here, vertically oriented means that the Josephson junction is established along a vertical axis (e.g., the Z-axis) and the different junction material layers are stacked along this vertical axis. Moreover, the interfaces between adjacent materials of the Josephson junction and the resulting Josephson junction area extend in a plane that is perpendicular to the vertical axis (e.g., the X-Y plane). A bottom electrode structure 110 of the quantum circuit has a contact portion 111 that is located inside the Josephson junction 101 and a coupling portion 112 that is located outside the Josephson junction 101. Hence, a part of the bottom electrode 110 extends beyond and out of the junction region. The coupling portion 112 of the bottom electrode 110 fits and extends into a corresponding recess 162 of a coupling head 161. A readout resonator structure 163, e.g. a coplanar waveguide structure, includes the coupling head 161 as an end portion, e.g., is terminated by the coupling head 161 or has one of its ends connected to the coupling head 161.Both the readout resonator structure 163 and the coupling head 161 form part of a larger readout circuit 160. Although not shown, additional elements of the readout circuit 160 may be present in the quantum circuit, e.g., a Purcell filter, a transmission line or a feed line capacitively coupled to the readout resonator 163.

As shown, recess 162 may be formed as a receiving slot for coupling portion 112. The latter exhibits a corresponding finger, prong or strip segment that suitably interlocks with the receiving slot in a non-contacting manner. Here, interlocking in a non-contact manner means that the coupling portion and the edge of the recess do not physically contact each other, thus avoiding a resistive connection, but are separated by a narrow insulating space or gap. This achieves good capacitive coupling between the coupling portion 112 and the coupling head 161 and hence between the bottom electrode 110 and readout resonator 163. The associated qubit-readout circuit coupling constant (coupling strength $g/2\text{-}2\pi$) may be about 3-10 MHz or larger, e.g. 3-50 MHz, for transmon qubit resonance frequencies in the range from 4 GHz to 10 GHz. Atomic layer deposition of the tunnel barrier layer may be preferred over sputter deposition if larger Josephson junction areas with thicker tunnel barriers are sought, which tend to achieve larger coupling strengths. In embodiments, the recess and coupling portion may be shaped and arranged in various other ways to interlock (without contacting each other) and provide good capacitive coupling.

The bottom electrode 110 preferably also includes a tapered section 113 that is connected between the coupling portion 112 outside the Josephson junction 101 and the contact region 111 inside the Josephson junction 101. Alternatively, coupling portion 112 may include a taper 113 which connects the contact portion to the coupling portion of the bottom electrode. Taper 113 ensures a smooth transition of the bottom electrode width (measured along the X-axis) from a narrower contact portion inside the Josephson junction 101 to a wider coupling portion outside the Josephson junction 101 and within the recess 162. A wider coupling portion of the bottom electrode outside the Josephson junction has the advantage of increasing the electrode surface area outside Josephson junction area, whereby stronger capacitive coupling between the bottom electrode and the readout circuit is obtained, without unduly increasing the capacitive coupling between the bottom electrode and the ground contact region. A smooth transition eliminates unwanted parasitic inductances or capacitances.

Spaced apart from the readout circuit 160, a ground contact region 150 provides a reference voltage to the readout resonator 163 and coupling head 161, e.g. a ground (GND) signal. The ground contact region 150, which can be implemented as a ground plane, extends from both sides of the readout resonator 163 and coupling head 161 towards the Josephson junction 101 and winds around the periphery of the Josephson junction 101 to surround the Josephson junction by following its outer circumference (i.e., perimeter). The opposite electrodes (top and bottom) of the vertical Josephson junction are both capacitively coupled to the ground plane 150. Good capacitive coupling between the top electrode of the Josephson junction 101 and the ground contact region 150 is obtained by having the ground contact region almost completely enclose or encircle the Josephson junction area, except for a narrow space at the tip of the Josephson junction 101 where the contact portion 111 of the bottom electrode 110 connects to the coupling portion 112.

An insulating space 102 - preferably an air gap or vacuum gap - extends between and separated the ground contact region 150 and the vertical Josephson junction 101 on the one hand and between the ground contact region 150 and the readout circuit 160 on the other hand. In the gapped region of quantum circuit 100, the bare substrate 140 may be exposed. Furthermore, the orientation and/or width dimension 'G' of gap 102 may be quasi constant locally but vary globally in the X-Y plane. For instance, the gap region between the edge of the Josephson junction 101 and ground plane 150 is narrower (of smaller width) as compared to gap region between the coupling head 161 and the ground plane 150. The gap width also increases along taper 113, starting from or close to the tip of Josephson junction. The gap width may be measured in a direction perpendicular to the gap-forming sidewalls (i.e. the surface-normal direction), whereas the gap orientation may be defined by curve of intersection between the substrate 140 plane and the lateral sidewalls of the ground contact region 150 interfacing the gap, or between the substrate 140 plane and the lateral sidewalls of the gap opposite to the sidewalls of the ground contact region, or a combination or average of both.

As shown, an inner edge or periphery of the ground contact region 150 and the outer edge or circumference of the Josephson junction 101 have complementary shapes such that the Josephson junction 101 is received or surrounded by a cavity-like planar indentation of the ground plane 150. Opposite sidewalls of the ground contact region 150 and the vertical Josephson junction are facing each other and are separated by gap 102, which may have a constant width 'G' along the perimeter of the Josephson junction 101.

The shape of the Josephson junction area, e.g. extending in the X-Y plane, is not limited to cross-like contours. The Josephson junction area may have a rectangular, rounded rectangular, oblong, polygonal, ellipsoidal, comb-like, double-sided comb-like or star-like shape. The Josephson junction area shapes may be defined by a linear, possibly curved path in the X-Y plane or may include different branches. In some embodiments, the Josephson junction may be oblong, line-shaped or formed as a thin and narrow structure that preferentially extend along a particular axis, e.g. a longitudinal axis which may be parallel to one of the X-axis and Y-axis, or oriented at an angle relative to the Y-Axis. Moreover, the Josephson junction area may be convex and/or concave in shape.

FIG. 2 is enlarged perspective view of the Josephson junction 101 tip that is pointing towards the coupling portion 112. The different vertically stacked layers that from the vertical Josephson junction 101 can be clearly distinguished. More specifically, the vertical Josephson junction 101 comprises the contact portion 111 of the bottom electrode 110, a tunnel barrier 130 on top of the contact portion 111 and a top electrode 120 atop the tunnel barrier The contact portion 111 of the bottom electrode 110 is located inside the Josephson junction 101 and the shape of the top electrode 120 may determine and delimit the Josephson junction area.

In the present example, the planar shapes of the contact portion 111, the tunnel barrier 130 and the top electrode 120 are substantially identical and horizontally aligned. This means that vertical projections of the respective edges of the contact portion 111, the tunnel barrier 130 and the top electrode 120 onto a common plane, e.g. a (bottom) plane of the substrate, coincide almost everywhere, except for a possible deviation at the nose or tip of the Josephson junction where the contact portion 111 of the bottom electrode 110 joins the coupling portion 112. A possible deviation may be less than 5 % of the total Josephson junction perimeter, e.g. less than 2 % of the junction perimeter, e.g. less than 1 % of the junction perimeter. Therefore, adjacent vertically extending sidewalls of the contact portion 111, the tunnel barrier 130 and the top electrode 120 are preferably contiguous with each other, except for the deviation at the nose or tip of the Josephson junction where the contact portion 111 of the bottom electrode 110 joins the coupling portion 112.

The quantum circuit 100 comprises a transmon qubit of the merged-element type. This means that the inherent self-capacitance of the vertical Josephson junction 101 acts as a shunting capacitor of the transmon qubit. Under these circumstances, no external shunt capacitor needs to be implemented and connected to the vertical Josephson junction. This enables reduced qubit device footprints and fabrication of higher area density quantum circuits containing the merged-element transmon qubits. In the present embodiment, the top electrode 120 and the contact portion 111 of the bottom electrode 110 form the two opposite capacitor plates of the shunting capacitor of the transmon qubit. To achieve the good charge noise suppression behaviour and anharmonicity typical of transmon qubits, the capacitor plates provided by the top electrode 120 and contact portion 111, and thus the resulting Josephson junction area, are chosen to have larger areal size than in conventional superconducting qubit devices. For instance, top electrode and corresponding Josephson junction areas may be about at least 1 $\mu$m$^2$. Moreover, the top electrode may be devoid of any sharp edges along its circumference, e.g. be formed with rounded edges where the circumference of the top electrode changes direction or makes a turn. This advantageously decreases coupling to potential local defects through excessively high electric fields.

Gap 102, e.g. comprising air or vacuum, separates the vertical Josephson junction 101 from the adjacent ground contact region 150. The narrow gap 102 enables capacitive coupling between the contact portion 111 of the bottom electrode 110 and the ground plane 150 as well as between the top electrode 120 and the ground plane 150 but prevents avoiding a resistive short-circuit. As shown, the gap-forming sidewalls of the ground plane 150 may be flared towards the tapered section 113 of the bottom electrode 110, at the tip of the Josephson junction, to gradually increase the width of the gap 102 away from the Josephson junction. Furthermore, a lower portion of gap 102 may be formed inside the underlying substrate 140. That is, the gap 102 may extend through the interface between the bottom electrode 110 and the substrate 140 and partially into the substrate 140. For instance, the bottom wall of the gap 102 and a lower portion 141 of the vertical walls delimiting the gap 102 may be formed in the substrate 140. In this case, the lower vertically extending wall portions 141 define a recessed portion on the upper surface of the substrate 140, which may coincide with the gapped region throughout the whole surface of the planar quantum circuit 100. Partially removing substrate material (e.g., substrate overetch) across the gap region 102 causes the bottom electrode 110, the coupling head 161 and the readout resonator structure 163 to be formed on and supported by pedestals of the substrate material 140. This has the benefit that a larger volume portion of the electric fringing field is present in the vacuum instead of the substrate dielectric, which may further reduce dielectric losses. Nonetheless, the bottom wall of gap 102 may correspond to the top surface of the substrate 140 in other embodiments of the invention, i.e., be located at the interface between the bottom electrode layer and the substrate underneath it.

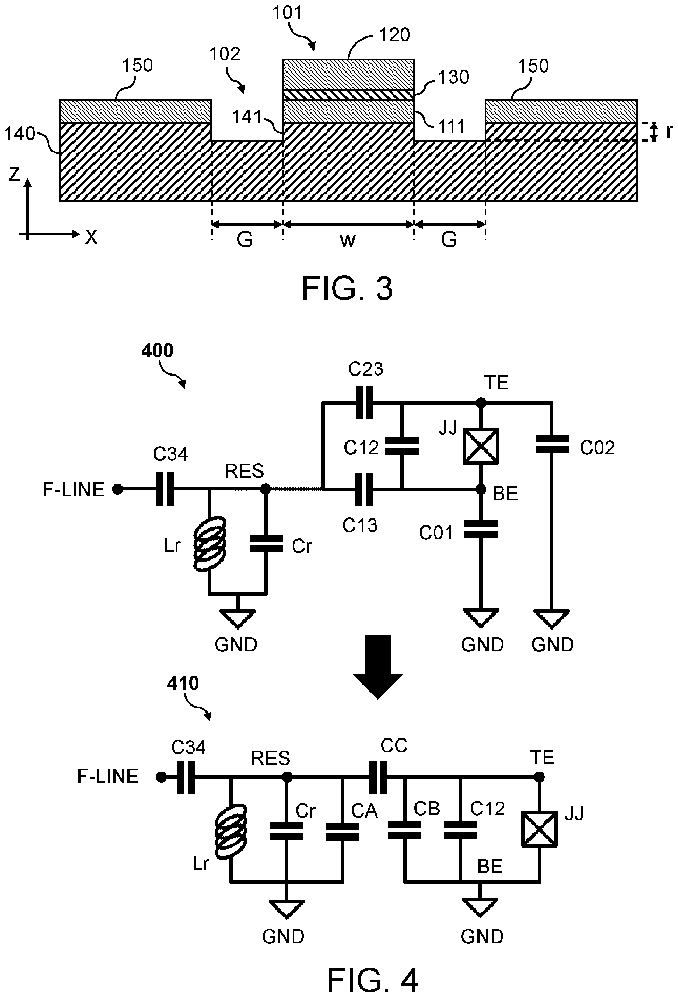

FIG. 3 is a cross-sectional view of the Josephson junction 101 which is taken along the line AA' in FIG. 1. As shown, the tri-layer Josephson junction 101 is formed over substrate 140 and is flanked, on both sides, by the ground contact region 150. The vertical sidewalls of the Josephson junction 101 and the ground contact region 150 are separated by gap 102. In the present embodiment, the bottom electrode 110 with contact portion 111 and the ground contact region 150 may be separate coplanar structures that have been formed in the same material layer. In this case, the top surfaces of the ground contact region 150 and the bottom electrode 110 may be located at the same vertical height (e.g. measured along the Z-axis).

In the present embodiment, a width of the vertical Josephson junction 101 in the X-direction may be about 100 nm or less. The gap 102 may have a width dimension of about 40 nm or less in the X-direction. The height or thickness of the bottom electrode 110 and the top electrode 120 in the Z-direction may be about 50 nm and 150 nm, respectively. The height or thickness of the tunnel barrier 130 in the Z-direction may be in the range of a few nanometers, e.g. 0,5 - 5,0 nm, e.g. between 1,2 - 4,5 nm. Exemplary values for the Josephson junction area and related shunt capacitance are 5,5 $\mu m^2$ and 125 fF for 4 nm thick ALD AlOx barriers and 1,7 $\mu m^2$ and 128 fF for 1,2 nm thick sputtered AlOx tunnel barriers, respectively. Superconducting bottom and top electrode may each comprise one of: Al, TiN, Nb, Ta, Mo, Pb, NbN, NbTiN. The tunnel barrier layer may include one of: AlOx, TaOx, Teflon, Si, GaN, SiC, SrTiO3, LaAlO3. The transmons qubits in accordance with the first embodiment may achieve energy ratios $E_J/E_C > 50$, resonance frequencies in the range 2-8 GHz and anharmonicity values $(\alpha/2\pi)$ above 100 MHz.

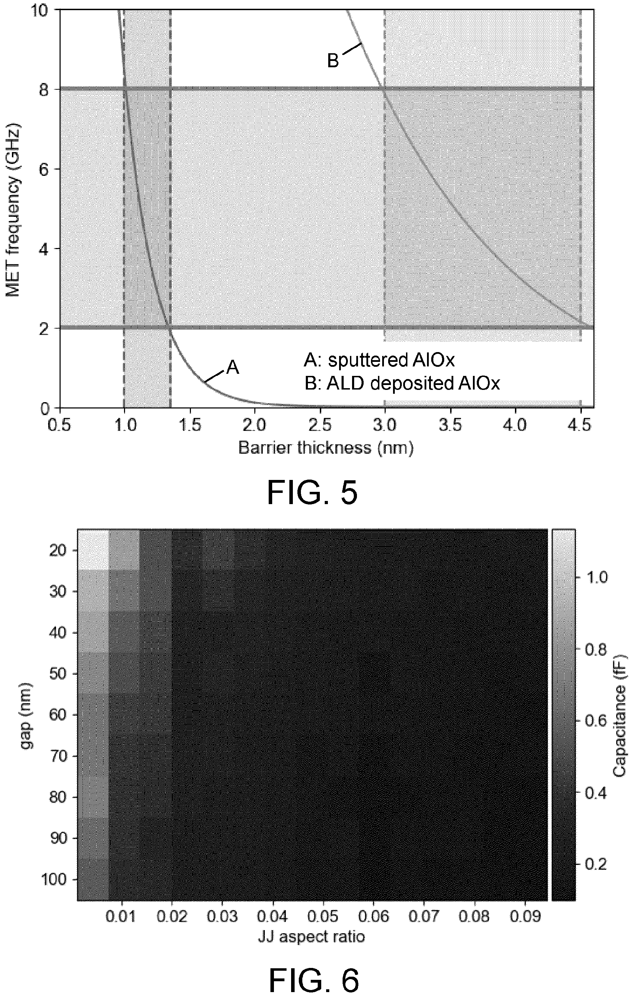

Furthermore, the resonance frequency of the floating merged-element transmon qubit, i.e. the qubit state transition frequency, may be independent of the Josephson junction area, e.g., the transmon qubit resonance frequency may be proportional to the expression sqrt(d*exp(-d)) with "d" being the tunnel barrier thickness. The dependence of the merged-element transmon (MET) qubit (resonance) frequency on the junction barrier thickness is graphically represented in FIG. 5, which clearly reveals the fast exponential decay of the MET qubit frequency with increasing barrier thicknesses for differently deposited aluminum oxide (AlOx) barrier materials, viz. sputter deposition and atomic layer deposition (ALD). This highlights the extreme sensitivity of the MET qubit frequency with respect to the barrier thickness and the barrier deposition or formation method, which is beneficial for the testing and characterization of different Josephson junction material combinations and manufacturing techniques. Typical MET qubit frequencies in the range 2-8 GHz are indicated by the rectangular window.

In the present embodiment, the bottom electrode 110, including the contact portion 111 and the coupling portion 112, the ground contact region 150 and the readout circuit 160, including the coupling head 161 and resonator structure 163, are coplanar structures commonly formed in a first superconducting material layer over the substrate 140. The tunnel barrier 130 is formed in an insulating barrier layer, e.g. dielectric material layer, between the first superconducting material layer and a second superconducting material layer. The top electrode 120 is formed in the second superconducting material layer, on top of the barrier layer.

The first and second superconducting material layer may have the same composition and include the same superconducting material, e.g. aluminum. The barrier layer may comprise a non-amorphous dielectric material, e.g. non-amorphous aluminum oxide. Alternatively, the first and second superconducting material layer each comprise one of: TiN, Nb, Ta, Mo, Pb, NbN, NbTiN. Other material choices for the tunnel barrier layer include one of: tantalum oxide, Teflon, Si, GaN, SiC, SrTiO3, LaAlO3. It is possible to provide a tunnel barrier layer which comprises or consists of an oxide of the superconducting metal of the first superconducting material layer. A suitable substrate material may be silicon, e.g. wafer-grade high-resistivity silicon, or sapphire.

Embodiments of the invention are not limited to superconducting material layers of the same composition. For example, the first superconducting material layer may comprise one of TiN, Nb, Ta, Mo, Pb, NbN, NbTiN and Al, while the second superconducting material layer comprises another one of TiN, Nb, Ta, Mo, Pb, NbN, NbTiN and Al.

FIG. 4 shows the equivalent electrical circuit diagram 400 for the quantum circuit of the first embodiment and its transformation into a simplified version 410. A readout resonator (RES) composed of a capacitance (Cr) and an inductance (Lr) is capacitively coupled - through capacitances C13 and C23 - to the electrodes (bottom electrode BE, top electrode TE) of the Josephson junction (JJ) on the one side and is capacitively coupled - through capacitance C34 - to a feedline (F-LINE) on the other side. A ground plane (GND) provides the reference potential to the circuit. The top electrode (TE) and the bottom electrode (BE) are also capacitively connected to the ground plane (GND) through the respective capacitances C01 and C02. The shunt capacitor inherent to the transmon qubit is represented by the capacitance C12. Assuming a sufficiently small capacitive coupling between the top electrode (TE) and the readout resonator (RES), i.e. a capacitance C23 tending towards zero, the equivalent capacitances of the simplified circuit 410 are:

$$CA \approx (C01*C13) / (C01+C02+C13),$$

$$CB \approx (C01*C02) / (C01+C02+C13),$$

and

$$CC \approx (C02*C13) / (C01+C02+C13)$$

Typically, one has CA << Cr and CB << C12. Representing the coupling strength between the transmon qubit and the readout circuit, a large coupling capacitance "CC" is preferred.

Providing the bottom electrode with the contact portion and the coupling portion as separate but connected parts, the capacitive coupling between the top electrode (TE) and the readout resonator (RES) can indeed be reduced to a negligible amount while strong capacitive coupling between the bottom electrode (TE) and the readout resonator (RES) is maintained. The coupling head for receiving the coupling portion of the bottom electrode further increases the capacitive coupling between the bottom electrode (TE) and the readout resonator (RES). Moreover, a top electrode (TE) that has a long perimeter compared to a compactly designed junction, is thick in proportion to the bottom electrode, and is separated from the ground contact region by a relatively narrow gap (e.g. narrower than the Josephson junction width) achieves stronger capacitive coupling to the ground contact region/ground plane. In consequence, a good coupling capacitance "CC" and corresponding coupling strength between the transmon qubit and the readout circuit can be realized in quantum circuits in accordance with embodiments of the invention.

In embodiments of the invention, the perimeter of the top electrode of the vertical Josephson junction can be advantageously increased by forming elongated or oblong Josephson junctions (e.g. strip-like, finger-like, or ellipsoidal junction area shapes) which have a small aspect ratio AR = w / L << 1,0, where 'w' refers to the characteristic junction width (e.g., along the X-axis) and 'L' refers to the characteristic junction length (e.g., measured along the Y-axis). For instance, one may constrain the aspect ratio to be AR ≤ 0,02. The aspect ratio criterion notwithstanding, it is possible to allow for different, e.g. non-oblong, area shapes of the Josephson junction and yet obtain long perimeters for the top electrode. An alternative design criterion for the vertical Josephson junction may be given as $P^2 \geq 200*A$, where 'A' designates the junction area and 'P' the junction perimeter or circumference. Moreover, good coupling strengths between the transmon qubit and the readout circuit can be achieved for gaps 102 surrounding the Josephson junction circumference, which obey the inequality $G*w^2/A < 1$ nm, where 'G' designates the characteristic gap width. There is a tradeoff between Josephson junction area and transmon qubit anharmonicity at given tunnel barrier thickness (or the thereby determined qubit frequency). This means that good selectivity in the transitions between the qubit states (e.g. between the fundamental state, the first excited state, and the second excited state) puts a practical upper limit on the size of the Josephson junction area. Different tunnel barrier materials may exhibit a different exponential scaling behavior of the resistance-area product as a function of the barrier thickness. Materials that benefit from a less pronounced thickness scaling in the resistance-area product may be preferred since this is opening the door to the design of even larger Josephson junction areas. The above-mentioned design criteria are useful for the design of quantum circuits in accordance with embodiments of the invention but are not essential. Other design criteria may be developed and adhered to.

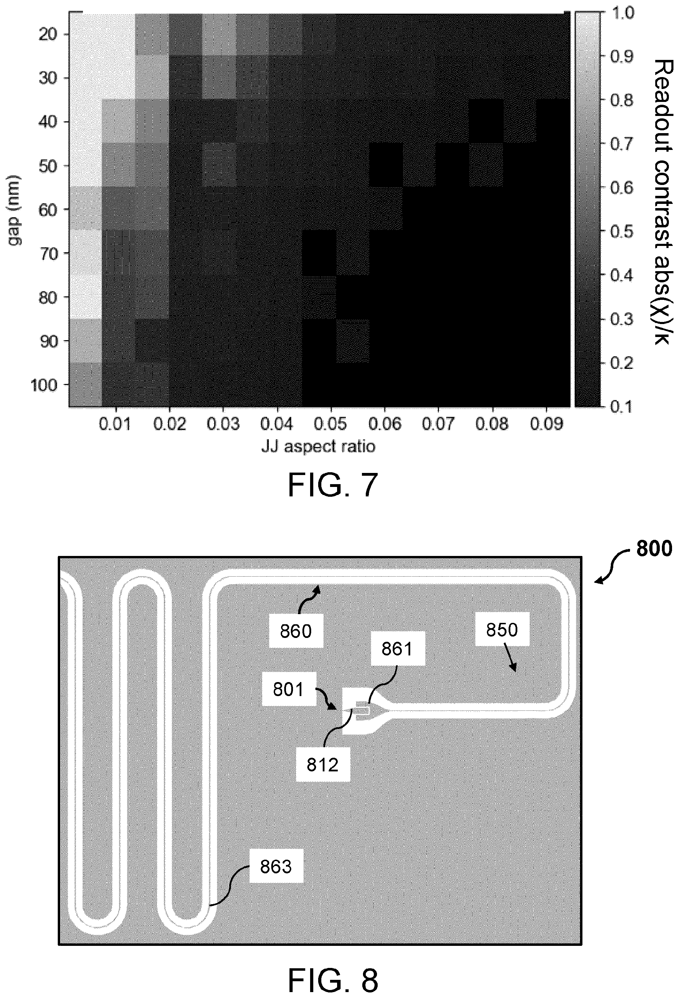

FIG. 6 and FIG. 7 illustrate the combined impact of the width of the circumferential gap surrounding the vertical Josephson junction and the aspect ratio of the Josephson junction area on the coupling capacitance C02 between the junction top electrode and the ground contact region and the readout contrast $|\chi| / \kappa$. Here, a vertically oriented Josephson junction with a sputter-deposited, 1,2 nm thick AlOx tunnel barrier and rounded rectangular shape has been assumed. The readout contrast is indicative of the qubit state-dependent, dispersive shift in the readout resonator frequency. It can be understood from the figures that small circumferential gap widths/spacings below 100 nm, e.g. below 60 nm, e.g. less than 40 nm, as well as small aspect ratios of less than 0,02 are preferred.

With reference to FIG. 8 through FIG. 10, a quantum circuit in accordance with a second embodiment of the invention is now described. FIG. 8 is a top view of a portion of a quantum circuit 800 which includes transmon qubit 801 with vertical Josephson junction, which is coupled to a readout circuit 860. The bottom electrode of the transmon qubit 801 comprises a coupling portion 812 that extends out of the Josephson junction region and into a complementarily shaped, recessed part of a coupling head 861. The planar readout circuit 860 contains a readout resonator structure 863, e.g. a coplanar waveguide, which is terminated by the coupling head 861. Compared with the quantum circuit of the first embodiments, a larger portion of readout resonator 863 within the quantum circuit 800 is shown in FIG. 8. As can be seen, a ground contact region 850 correspond to a large-area ground plane that is common to the readout resonator 863 and the transmon qubit 801. The ground contact region 850, the readout resonator 863 with coupling head 861 and the bottom electrode with coupling portion 812 may be formed as coplanar structures with a same layer, e.g. a first superconductor containing layer.

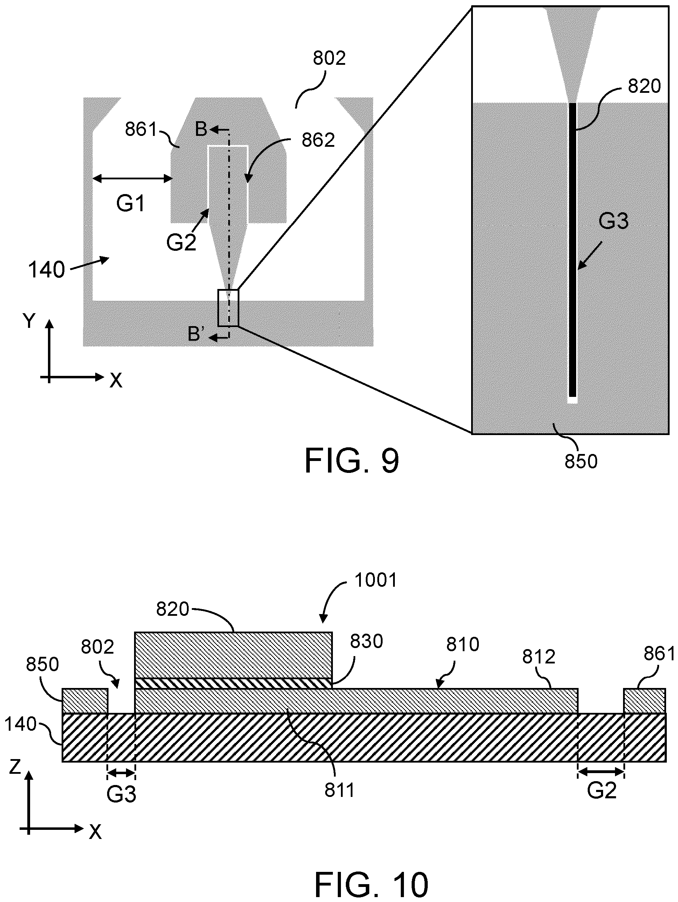

Magnifications of the transmon qubit 801 of quantum circuit 800 are shown in FIG. 9. A gap region 802 of the planar quantum circuit 800 delimits the ground plane 850 and separates it from both the readout circuit 860 and the transmon qubit 801. Around the transmon qubit 801, e.g. adjacent to the periphery or outer sidewalls of the vertical Josephson junction, the gap region 802 constitutes a narrow circumferential space or nonconductive channel. This narrow circumferential space widens to a broader channel at the extremity of the Josephson junction where the contact portion 811 of the bottom electrode 810 abuts the coupling portion 812. An associated gap dimension (e.g. gap width along the X-axis) increases from G3 to G1. A second narrow circumferential space, e.g. having an associated gap dimension G2, provides a corridor that connects to the broad trenches of the gap region extending from either side of the coupling portion 812 that is not located inside the coupling head recess 862. The second narrow circumferential space follows the edge of the coupling head recess 862 and may be wider than the first narrow circumferential space bordering the vertical Josephson junction sidewalls, i.e. G1 >> G2 > G1. This reduces the capacitive coupling strength between the bottom electrode 810 and the ground contact region 850 but strengthens the capacitive coupling between bottom electrode 810 and readout resonator 863 (via the interlocking coupling portion 812 and coupling head 861) and between transmon qubit top electrode 820 and ground contact region 850. In the gap region 802, the top surface of the underlying substrate 140 may be exposed. FIG. 10 is a cross-sectional view taken along the line BB', which illustrates the different connected portions 811 and 812 of the bottom electrode 810, respectively located inside and outside the vertical Josephson junction region 1001, as well as the gap spaces of dimensions G2 and G3 that separate the bottom electrode 810 from the coupling head 861 and the ground contact region 850 at each one of its respective ends. In contrast to the quantum circuit of the first embodiment, the quantum circuit 800 according to the second embodiment does not display substrate material removal across the gap region 802. This means that no vertical sidewalls are formed in the underlying substrate 140 and exposed to the gap-filling medium (e.g. air or vacuum or inert gas). Furthermore, the bottom electrode 810, the coupling head 861 and the readout resonator structure 863 are not formed on and supported by pedestals of the substrate material 140.

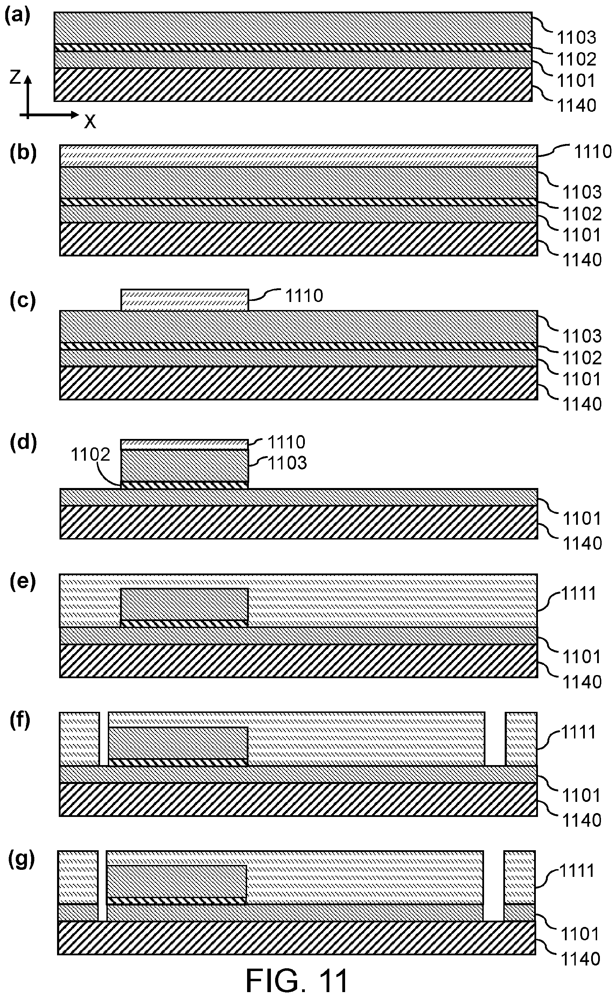

FIG. 11 illustrates steps (a) through (f) of a method for manufacturing a quantum circuit according to embodiments of the invention. In a first step (a), a multilayer stack is provided that contains at least a first superconductor in a first layer 1101 formed on or over a substrate 1140, an insulator in a second layer 1102 formed on or over the first layer 1101, e.g. formed directly on and in physical contact with the first layer 1101, and a second superconductor in a third layer 1103 formed on or over the second layer 1102, e.g. formed directly on and in physical contact with the second layer 1102. The material or composition of the first and second superconductor may be identical, e.g. both comprising or consisting of one of Al, Ta, TiN, and Nb. Alternatively, the first and second superconductor may have different compositions. The insulator may be a dielectric material, e.g. comprising or consisting of AlOx, Teflon or TaOx. The substrate may comprise silicon, e.g. high-resistivity silicon. The multilayer stack may be provided on a wafer, e.g. in a wafer-scale manufacturing method. Providing the multilayer stack may include the preceding steps of depositing the first layer comprising the first superconductor (e.g. a thin film) on or over the substrate, depositing or forming the second layer comprising the insulator (e.g. a thin film) on or over the first layer, and depositing the third layer comprising the second superconductor (e.g. a thin film) on or over the second layer. The multilayer stack may be provided as an epitaxial stack. In embodiments, depositing the first and third layer, respectively comprising the first and second superconductor, may include layer deposition by sputtering techniques, atomic layer deposition (ALD) or suitable epitaxial stackgrowing techniques. Forming the second layer comprising the insulator may comprise partially oxidizing an upper portion of the first layer, e.g. in a controlled ambient atmosphere.

A photoresist 1110 is applied to the material layer stack in step (b) and lithographically patterned in step (c) to define the structure for the top electrode of the transmon qubit. Lithographic patterning may include exposing the photoresist layer 1110 to irradiation through an exposure mask or sequence of masks, or exposing the photoresist layer 1110 to focused irradiation that is scanned across the photoresists layer. The photoresist is sensitive to the irradiation used for exposure, which may be optical or electron beam radiation. The choice of resist tonality and corresponding mask design (inverse or not) is non-limiting, but a negative resist may be preferred in embodiments that use e-beam writing techniques for lithography, whereby writing/exposure times can be reduced. Lithographic patterning may further include developing the photoresist after exposure and selectively removing unexposed portions of the photoresists. This creates openings in the stack for etching of the layers below but protects the structure to be transferred into the layers below, e.g. the top electrode structure to be transferred into the third layer 1103 comprising the second superconductor and optionally further into the second layer 1102 comprising the insulator.

Portions of the third and second layer 1103, 1102 which are not protected by the remaining resist 1110 are subsequently removed in step (d), e.g. by a selective etch step or sequence of etch steps. This transfers the top electrode structure to the third layer 1103 and further into the second layer 1102. Combining the selective removal of material of the third and second layer 1103, 1102 has the advantage that aligned structures for the top electrode and tunnel barrier of the vertical Josephson junction can be obtained with a single lithographic alignment step. In embodiments, the same or a different etchant may be used to first selectively remove material from the third layer 1103 and then continue selectively removing material from the second layer 1102 too. The choice of the etchant or sequence of etchants generally depends on the material choices for the second superconductor and insulator in these two layers.

In the following steps (e) to (f), the remainder of the first resist 1110 is stripped off and a second photoresist layer 1111 is applied to the stack and lithographically patterned to define the structures for the first layer 1101. The bottom electrode and the readout resonator with coupling head are structures that need to be formed in the first layer 1101 comprising the first superconductor. It may be advantageous to also define other portions of the readout circuit at the same time as the resonator. In embodiments in which the ground contact region, e.g. ground plane, is coplanar with the bottom electrode, the ground plane structure is also defined lithographically in steps (e) to (f). Lithographic patterning of the second resist layer 1111 may be performed similarly to previous step (c). The first resist 1110 and the second resist 1111 may have the same or different compositions. In embodiments using e-beam writing techniques, a positive tone resist may be preferred to reduce the writing time.

Next, portions of the first superconductor in the first layer 1101 that are not protected by the remaining resist 1111 are selectively removed in step (g), e.g. by a selective etch step or sequence of etch steps. This transfers the bottom electrode structure, the ground plane structure and the readout circuit structure (including the readout resonator and coupling head structures) to the first layer 1101. Stripping off the remaining resist 1111 from the processed multilayer stack yields a quantum circuit as shown in the cross-section of FIG. 10.

It is an advantage of embodiments of the invention that only removal and no addition of material is required to obtain quantum circuits in accordance with embodiments of the invention. Moreover, as little as two lithographic patterning and alignment steps may be required. A prefabricated multilayer material stack with precisely deposited/formed layers and little to no significant surface and/or interface defects can be used.

It is possible to over-etch the first layer 1101 in step (g), i.e. continue etching through the top surface and into the underlying substrate 1140, such that the structures for the first layer 1101 are also partially transferred into the substrate 1140. This allows to form corresponding pedestals in the substrate that support and superelevate the structures of the first layer 1101 with respect to the exposed upper surface of the underlying substrate (e.g., the bottom wall of the gap region 102 in the quantum circuit 100 of the first embodiment). Combining the selective removal of material of the first layer 1101 and the selective, partial removal of substrate material has the advantage that aligned structures can be obtained in these layers with just a single lithographic alignment step. In embodiments, the same or a different etchant may be used to first selectively remove material from the first layer 1101 and then continue selectively removing material from the substrate 1140 too. The choice of the etchant or sequence of etchants generally depends on the material choices for the second superconductor and insulator in these two layers.

In a variant of the manufacturing method, the structures for the first layer 1101, e.g. the bottom electrode, ground contact region and readout circuit structures, are defined in the first resists 1110 and subsequently transferred to the first layer 1101 by selectively removing (e.g. etching away) corresponding material in the layers 1102, 1103 above. The second lithographic patterning step related to the second resist 1111 may then be used to define and protect the structures for the top electrode and the tunnel barrier in the third and second layer, respectively. This way, excess material in the third and second layer 1103, 1102 that does not belong to the top electrode and tunnel barrier structure can be removed to expose the coupling portion, ground plane and readout circuit within the first layer 1101.

While the invention has been illustrated and described in detail in the drawings and foregoing description, such illustration and description are to be considered illustrative or exemplary and not restrictive. Other variations to the disclosed embodiments can be understood and effected by those skilled in the art in practicing the claimed invention, from a study of the drawings, the disclosure and the appended claims. In the claims, the word "comprising" does not exclude other elements or steps, and the indefinite article "a" or "an" does not exclude a plurality. Any reference signs in the claims should not be construed as limiting the scope.

**Claims**

1. A quantum circuit (100) comprising:

    a bottom electrode (110) formed in a first superconducting material layer, the bottom electrode comprising a contact portion (111) and a coupling portion (112),

a top electrode (120) formed in a second superconducting material layer,

a vertical Josephson junction (101) formed over a substrate (140), the Josephson junction comprising the contact portion of the bottom electrode, a tunnel barrier (130) and the top electrode,

a transmon qubit comprising the vertical Josephson junction (101) and a shunt capacitor formed by the top electrode and the contact portion of the bottom electrode as shunt capacitor plates, and

a readout circuit (160) capacitively coupled to the bottom electrode via the coupling portion, the readout circuit comprising a coupling head (161), the coupling portion of the bottom electrode being fitted into a recess (162) formed in said coupling head, wherein the top electrode of the vertical Josephson junction is configured as a floating electrode, not resistively coupled to the first superconducting material layer.

2. The quantum circuit (100) of claim 1, wherein the readout circuit (160) comprises a readout resonator (163) such as a coplanar waveguide, an end portion of said readout resonator comprising said coupling head (161) of the readout circuit.

3. The quantum circuit (100) of claim 2, wherein at least the readout resonator of the readout circuit is formed in the first superconducting material layer.

4. The quantum circuit (100) of any one of the preceding claims, further comprising a ground contact region (150) adjacent to the vertical Josephson junction (101), said ground contact region being formed in the first superconducting material layer or in a third superconducting material layer atop the second superconducting material layer.

5. The quantum circuit (100) of claim 4, wherein a gap (102) is separating the ground contact region (150) from sidewalls of the vertical Josephson junction, said gap having a width of at most 100 nm in a normal direction to said sidewalls.

6. The quantum circuit (100) of any one of the preceding claims, wherein the recess (162) in the coupling head (161) is formed as a receiving slot with respect to the coupling portion of the bottom electrode.

7. The quantum circuit (100) of any one of the preceding claims,

wherein the vertical Josephson junction (101) has a characteristic junction length (L) along a first direction parallel to the substrate (140) and has a characteristic junction width (w) along a second direction parallel to the substrate, the second direction being perpendicular to the first direction, and wherein the ratio of characteristic junction width to characteristic junction length is at most 0,02,

or wherein the vertical Josephson junction (101) has a junction area of size 'A' and a junction perimeter of length 'P' such that $P^2 \geq 200*A$.

8. The quantum circuit (100) of any one of the preceding claims, further comprising a ground contact region (150) adjacent to the vertical Josephson junction (101), the vertical Josephson junction having an oblong shape of width 'w' and area 'A', and a gap (102) separating the ground contact region from the sidewalls of the vertical Josephson junction having a gap width 'G' such that $G*w^2/A < 1$ nm.

9. The quantum circuit (100) of any one of the preceding claims, wherein the first and second superconducting material layers comprise aluminium, and/or wherein the tunnel barrier (130) is formed in a dielectric layer, preferably comprising an aluminium oxide.

10. The quantum circuit (100) of any one of the preceding claims, further comprising a ground contact region (150) adjacent to the vertical Josephson junction (101), said ground contact region surrounding the contact portion (111) of the bottom electrode (110).

11. The quantum circuit (100) of any one of the preceding claims, wherein sidewalls of the vertical Josephson junction are free of deposited dielectric residuals.

12. The quantum circuit (100) of any one of the preceding claims, wherein sidewalls of the tunnel barrier (130) are interfacing air or vacuum.

13. A method of manufacturing a quantum circuit, comprising:

providing a multilayer material stack comprising a first superconducting material, a dielectric layer and second superconducting material on a substrate,

forming a bottom electrode in the first superconducting material, said bottom electrode comprising a contact portion and a coupling portion,

forming a top electrode in the second superconducting material,

forming a transmon qubit comprising a vertical Josephson junction and a shunt capacitor, the vertical Josephson junction comprising the contact portion of the bottom electrode, a tunnel barrier formed in the dielectric layer and the top electrode, and the shunt capacitor formed by the top electrode and the contact portion of the bottom electrode as shunt capacitor plates, and capacitively coupling a readout circuit to the bottom electrode, including fitting the coupling portion of the bottom electrode into a recess formed in a coupling head of the readout circuit, wherein the top electrode of the vertical Josephson junction is configured as a floating electrode, not resistively coupled to the first superconducting material layer.

14. The method of claim 13, further comprising: adjacent to the vertical Josephson junction, forming a ground contact region in the first superconducting material layer or in a third superconducting material layer atop the second superconducting material layer.

15. The method of claim 13 or 14, wherein the step of forming the top electrode comprises: patterning and selectively removing material from the second superconducting material layer, and optionally also from the dielectric layer; and the step of forming the bottom electrode comprises: patterning and selectively removing material from the first superconducting material layer, and optionally also from the substrate.

FIG. 1

FIG. 2

FIG. 3

FIG. 4

FIG. 5

FIG. 6

FIG. 7

FIG. 8

FIG. 9

FIG. 10

(a)

Z

X

1103
1102
1101
1140

(b)

1110

1103
1102
1101
1140

(c)

1110

1103
1102
1101
1140

(d)

1102
1110
1103

1101
1140

(e)

1111

1101
1140

(f)

1111

1101
1140

(g)

1111

1101
1140

## FIG. 11

Europäisches
Patentamt

European
Patent Office

Office européen
des brevets

## EUROPEAN SEARCH REPORT

**Application Number**

EP 24 20 6694

### DOCUMENTS CONSIDERED TO BE RELEVANT

| Category | Citation of document with indication, where appropriate, of relevant passages | Relevant to claim | CLASSIFICATION OF THE APPLICATION (IPC) |
|---|---|---|---|
| X | MAMIN H.J. ET AL: "Merged-Element Transmons: Design and Qubit Performance", PHYSICAL REVIEW APPLIED, vol. 16, no. 2, 13 August 2021 (2021-08-13), XP093127629, ISSN: 2331-7019, DOI: 10.1103/PhysRevApplied.16.024023 Retrieved from the Internet: URL:https://journals.aps.org/prapplied/pdf/10.1103/PhysRevApplied.16.024023> * abstract; sections I-III; figure 1 * | 1-15 | INV. G06N10/40 H10N60/01 H10N60/80 H10N69/00 |
| X | US 2019/296213 A1 (BRINK MARKUS [US] ET AL) 26 September 2019 (2019-09-26) * paragraphs [0045], [0046], [0059], [0063], [0065], [0066], [0068], [0117]; figures 1-4, 6 * | 1-15 | |
| X | ZHAO R ET AL: "Merged-element transmon", ARXIV.ORG, CORNELL UNIVERSITY LIBRARY, 201 OLIN LIBRARY CORNELL UNIVERSITY ITHACA, NY 14853, 1 December 2020 (2020-12-01), XP081826851, DOI: 10.1103/PHYSREVAPPLIED.14.064006 * section I-III; figure 1 * | 1-15 | TECHNICAL FIELDS SEARCHED (IPC) G06N H10N H01L |
| A | MO CHEN ET AL: "Phonon engineering of atomic-scale defects in superconducting quantum circuits", ARXIV.ORG, CORNELL UNIVERSITY LIBRARY, 201 OLIN LIBRARY CORNELL UNIVERSITY ITHACA, NY 14853, 5 October 2023 (2023-10-05), XP091889527, DOI: 10.1126/SCIADV.ADO6240 * figures 1(b), 1(c) * | 1-15 | |

-/--

The present search report has been drawn up for all claims

| Place of search | Date of completion of the search | Examiner |
|---|---|---|
| The Hague | 21 March 2025 | Keane, Shane |

CATEGORY OF CITED DOCUMENTS

X : particularly relevant if taken alone
Y : particularly relevant if combined with another document of the same category
A : technological background
O : non-written disclosure
P : intermediate document

T : theory or principle underlying the invention
E : earlier patent document, but published on, or after the filing date
D : document cited in the application
L : document cited for other reasons

& : member of the same patent family, corresponding document

EPO FORM 1503 03.82 (P04C01)

Europäisches
Patentamt
European
Patent Office
Office européen
des brevets

# EUROPEAN SEARCH REPORT

**Application Number**

EP 24 20 6694

## DOCUMENTS CONSIDERED TO BE RELEVANT

| Category | Citation of document with indication, where appropriate, of relevant passages | Relevant to claim | CLASSIFICATION OF THE APPLICATION (IPC) |
|---|---|---|---|
| A | EP 4 328 809 A1 (ORIGIN QUANTUM COMPUTING TECH HEFEI CO LTD [CN]) 28 February 2024 (2024-02-28) * figures 1A, 1B * ----- | 1-15 | |

**TECHNICAL FIELDS SEARCHED (IPC)**

The present search report has been drawn up for all claims

| Place of search | Date of completion of the search | Examiner |
|---|---|---|
| The Hague | 21 March 2025 | Keane, Shane |

CATEGORY OF CITED DOCUMENTS

X : particularly relevant if taken alone
Y : particularly relevant if combined with another
   document of the same category
A : technological background
O : non-written disclosure
P : intermediate document

T : theory or principle underlying the invention
E : earlier patent document, but published on, or
   after the filing date
D : document cited in the application
L : document cited for other reasons

& : member of the same patent family, corresponding
   document

EPO FORM 1503 03.82 (P04C01)

## ANNEX TO THE EUROPEAN SEARCH REPORT
## ON EUROPEAN PATENT APPLICATION NO.

EP 24 20 6694

This annex lists the patent family members relating to the patent documents cited in  the above-mentioned European search report.
The members are as contained in the European Patent Office EDP file on
The European Patent Office is in no way liable for these particulars which are merely given for the purpose of information.

21-03-2025

| Patent document cited in search report | | Publication date | Patent family member(s) | | Publication date |
|---|---|---|---|---|---|
| US 2019296213 | A1 | 26-09-2019 | CN | 111902941 A | 06-11-2020 |
| | | | EP | 3769340 A1 | 27-01-2021 |
| | | | JP | 2021518654 A | 02-08-2021 |
| | | | US | 10256392 B1 | 09-04-2019 |
| | | | US | 2019296213 A1 | 26-09-2019 |
| | | | WO | 2019179731 A1 | 26-09-2019 |
| EP 4328809 | A1 | 28-02-2024 | EP | 4328809 A1 | 28-02-2024 |
| | | | US | 2024322823 A1 | 26-09-2024 |
| | | | WO | 2023006041 A1 | 02-02-2023 |

EPO FORM P0459

For more details about this annex : see Official Journal of the European Patent Office, No. 12/82

**REFERENCES CITED IN THE DESCRIPTION**

*This list of references cited by the applicant is for the reader's convenience only. It does not form part of the European patent document. Even though great care has been taken in compiling the references, errors or omissions cannot be excluded and the EPO disclaims all liability in this regard.*

**Non-patent literature cited in the description**

- **ZHAO, RUICHEN et al.** Merged-element transmon. *Physical Review Applied*, 2020, vol. 14 (6)